(19) **Europäisches Patentamt / European Patent Office / Office européen des brevets**

(11) **EP 3 469 386 B1**

(12) **FASCICULE DE BREVET EUROPEEN**

(45) Date de publication et mention de la délivrance du brevet:
**19.02.2020 Bulletin 2020/08**

(21) Numéro de dépôt: **17783903.2**

(22) Date de dépôt: **09.06.2017**

(51) Int Cl.:
*G01R 19/04* (2006.01)  *G01R 19/175* (2006.01)
*G01R 25/00* (2006.01)  *G06F 17/12* (2006.01)
*G06F 17/16* (2006.01)  *G01P 3/14* (2006.01)
*G01P 15/18* (2013.01)  *G06F 17/14* (2006.01)

(86) Numéro de dépôt international:
**PCT/FR2017/051464**

(87) Numéro de publication internationale:
**WO 2017/212187 (14.12.2017 Gazette 2017/50)**

(54) **SYSTEME ET PROCEDE POUR FOURNIR L'AMPLITUDE ET LE RETARD DE PHASE D'UN SIGNAL SINUSOÏDAL**

SYSTEM UND VERFAHREN ZUR BEREITSTELLUNG DER AMPLITUDE UND PHASENVERZÖGERUNG EINES SINUSFÖRMIGEN SIGNALS

SYSTEM AND METHOD FOR PROVIDING THE AMPLITUDE AND PHASE DELAY OF A SINUSOIDAL SIGNAL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **10.06.2016 FR 1655330**

(43) Date de publication de la demande:
**17.04.2019 Bulletin 2019/16**

(73) Titulaire: **Office National d'Etudes et de Recherches Aérospatiales 91120 Palaiseau (FR)**

(72) Inventeurs:
• **GUERARD, Jean**
**91260 JUVISY-SUR-ORGE (FR)**
• **VERLHAC, Béatrice**
**92130 ISSY LES MOULINEAUX (FR)**
• **LAVENUS, Pierre**
**92260 FONTENAY AUX ROSES (FR)**
• **LEVY, Raphaël**
**75014 PARIS (FR)**

(74) Mandataire: **Plasseraud IP 66, rue de la Chaussée d'Antin 75440 Paris Cedex 09 (FR)**

(56) Documents cités:
**WO-A1-2008/022653     US-A1- 2003 174 797
US-A1- 2004 085 096**

• **Edward Lee ET AL: "Sampling and Reconstruction", Structure and Interpretation of Signals and Systems, 1 janvier 2003 (2003-01-01), pages 373-392, XP055354015, ISBN: 978-0-201-74551-1 Extrait de l'Internet: URL:https://chess.eecs.berkeley.edu/eecs12 4/reading/LeeAndVaraiya11.pdf [extrait le 2017-03-13]**
• **HILL G: "THE BENEFITS OF UNDERSAMPLING", ELECTRONIC DESIGN, PENTON MEDIA, CLEVELAND, OH, US, vol. 42, no. 14, 11 juillet 1994 (1994-07-11), XP000459838, ISSN: 0013-4872**
• **Roberto Micheletti: "Phase Angle Measurement Between Two Sinusoidal Signals", IEEE Trans. Instr. Meas. vol. 40, no. 1, 1 février 1991 (1991-02-01), pages 40-42, XP055353815, Extrait de l'Internet: URL:http://ieeexplore.ieee.org/ielx1/19/24 52/00069948.pdf?tp=&arnumber=69948&isnumb e r=2452 [extrait le 2017-03-10]**

- **BAPTISTE MARECHAL ET AL: "Direct digital synthesiser (DDS) design parameters optimisation for vibrating MEMS sensors: Optimisation of phase accumulator, Look-Up Table (LUT) and Digital to Analog Converter (DAC) sizes", 2014 SYMPOSIUM ON DESIGN, TEST, INTEGRATION AND PACKAGING OF MEMS/MOEMS (DTIP), CIRCUITS MULTI PROJETS - CMP, 1 avril 2014 (2014-04-01), pages 1-5, XP032746454, DOI: 10.1109/DTIP.2014.7056692 ISBN: 978-2-35500-028-7 [extrait le 2015-03-09]**

- **K.R. Rao ET AL: "Discrete Fourier Transform" In: "Digital Video and Audio Broadcasting Technology: A Practical Engineering Guide (3rd edition)", 1 janvier 2010 (2010-01-01), XP055354004, ISSN: 1860-4862 ISBN: 978-3-642-11611-7 pages 5-40, DOI: 10.1007/978-1-4020-6629-0_2, le document en entier**

**Description**

La présente invention concerne un système et un procédé pour fournir l'amplitude et le retard de phase d'un signal sinusoïdal.

Dans la présente description, on appelle retard de phase d'un signal sinusoïdal l'opposée de la valeur de la phase de ce signal pour un instant d'origine, aussi appelé instant initial et correspondant à $t = 0$, où $t$ désigne la variable de temps.

De nombreuses applications requièrent de caractériser un signal sinusoïdal par son amplitude et son retard de phase. Tel est le cas notamment pour caractériser la réponse d'un résonateur à un signal d'excitation, le résonateur pouvant être une partie d'un accéléromètre vibrant ou d'un gyromètre vibrant.

Une des façons les plus courantes pour cela consiste à numériser le signal sinusoïdal, puis à l'analyser, par exemple par transformation de Fourier. Or la numérisation d'un signal, comprenant son échantillonnage à des instants déterminés et la quantification des valeurs du signal qui sont effectives à ces instants, est réalisée en utilisant des convertisseurs analogiques-numériques qui sont des composants électroniques mixtes, réalisés dans des technologies spécifiques de semi-conducteurs. A ce titre, les convertisseurs analogiques-numériques nécessitent des développements importants pour être qualifiés pour des applications spatiales, ce qui augmente leur prix de revient.

Pour éviter ces inconvénients des convertisseurs analogiques-numériques, il est connu par ailleurs, notamment du document US 5,166,959, de caractériser un signal sinusoïdal en repérant les instants d'annulation de ce signal. Mais une telle méthode ne permet pas de déterminer l'amplitude du signal sinusoïdal, mais seulement son retard de phase, et est peu précise lorsque l'amplitude du signal est faible et/ou présente un rapport signal-sur-bruit qui est faible.

Le document WO 2008/022653 divulgue un système de mesure de sinusoïde, qui est basé sur des dates de comparaison d'un signal à identifier avec un signal de référence.

Par ailleurs, l'article de R. Micheletti qui est intitulé «Phase Angle Measurement Between Two Sinusoïdal Signais», IEEE Trans. Instr. Meas. Vol.40, No.1, 1er février 1991, pp.40-42, XP055353815, propose un algorithme pour mesurer l'angle de phase entre deux signaux. L'algorithme est basé sur une méthode par moindres carrés et est mis en oeuvre à partir de signaux numériques.

Enfin, l'article de B. Maréchal et al., qui est intitulé «Direct Digital Synthetizer (DDS) design parameters optimisation for vibrating MEMS sensors», 2014 SYMPOSIUM ON DESIGN, TEST, INTEGRATION AND PACKAGING OF MEMS/MOEMS (DTIP), CIRCUITS MULTI PROJETS - CMP - 1er avril 2014, pp.1-5, XP032746454, propose des conceptions optimisées d'unités numériques de synthèse de signaux.

A partir de cette situation, un but de l'invention consiste à déterminer l'amplitude et le retard de phase d'un signal sinusoïdal d'une nouvelle façon, sans nécessiter de convertisseur analogique-numérique.

Un but annexe de l'invention consiste à fournir un système apte à déterminer l'amplitude et le retard de phase d'un signal sinusoïdal, qui soit peu onéreux et qui puisse être qualifié pour des applications spatiales à coût réduit.

Un autre but de l'invention consiste à fournir un tel système dont une partie importante puisse être partagée entre plusieurs voies qui sont dédiées chacune à déterminer l'amplitude et le retard de phase d'un signal sinusoïdal différent de celui des autres voies, toutes les voies opérant continuellement et simultanément.

Enfin, encore un autre but de l'invention consiste à fournir un tel système qui soit précis même pour un signal sinusoïdal de faible amplitude, éventuellement superposé à du bruit.

Pour atteindre l'un au moins de ces buts ou d'autres, un premier aspect de l'invention propose un système pour fournir une valeur d'amplitude et une valeur de retard de phase relatives à un signal à mesurer selon la revendication 1.

Ainsi, le système de l'invention procède par identification des valeurs de la phase du signal de référence, pour lesquelles le signal à mesurer devient plus petit que le signal de référence, ou plus grand que celui-ci. A partir de ces valeurs de phase, l'unité de calcul détermine l'amplitude et le retard de phase du signal à mesurer.

Le système de l'invention n'utilise donc aucun convertisseur analogique-numérique pour déterminer l'amplitude et le retard de phase du signal sinusoïdal à mesurer.

L'unité de synthèse du signal de référence et le registre à bascules sont des composants numériques simples, peu onéreux et qui peuvent être qualifiés sans développements importants pour des applications spatiales, dès lors que des fonctions numériques de base le sont dans une technologie donnée. Quant au comparateur, il s'agit d'une fonction mixte mais sans difficulté, qui peut se ramener à une simple paire différentielle de transistors.

Il en est de même pour l'unité de calcul, qui peut comprendre ou être réalisée sous forme d'un circuit spécialisé, ou circuit intégré spécifique pour une application, désigné par l'acronyme ASIC, ou sous forme d'un circuit programmable, désigné par l'acronyme FPGA, et pour lesquels les niveaux d'intégration réalisables ont fortement augmenté ces dernières années, en même temps que leurs prix de revient ont fortement diminué. En effet, l'amplitude et le retard de phase du signal à mesurer peuvent être calculés en réalisant principalement des opérations d'addition, de multiplication et de soustraction de nombres, pour partie avec des valeurs de nombres qui sont fixes et qui peuvent donc être préenregistrées. De façon connue, la conception et la description de l'unité de calcul sous forme d'un ASIC ou d'un FGPA peut être effectuée de façon très souple et économique dans des langages tels que VHDL ou Verilog. De façon générale pour l'invention, au moins l'un parmi l'unité de synthèse, le registre à bascule et l'unité de calcul peut avantageusement être formé par un tel circuit spécialisé (ASIC) ou par un tel circuit logique programmable (FPGA).

Enfin, étant donné que les instants qui sont repérés concernent la comparaison du signal à mesurer avec un signal de référence variable, la précision avec laquelle ces instants peuvent être repérés peut être bonne même si le signal à mesurer possède une amplitude qui est faible et est perturbé par du bruit.

Dans des modes préférés de réalisation de l'invention, le nombre P peut être égal au nombre Q augmenté d'une unité : P = Q + 1.

Selon une première conception possible de l'unité de calcul, celle-ci peut réaliser une résolution exacte du système des équations affines ayant pour inconnues les valeurs d'amplitudes en phase a·cosΦ et en quadrature de phase a·sinΦ du signal à mesurer. Dans ce cas, l'unité de calcul peut être adaptée pour calculer les coefficients du système d'équations affines à partir des valeurs sélectionnées de la phase du signal de référence, et pour calculer les valeurs des amplitudes en phase et en quadrature de phase du signal à mesurer en appliquant un algorithme de résolution de ce système d'équations affines. En particulier, un algorithme d'inversion d'équations affines ou un algorithme de résolution par moindres carrés peut être mis en œuvre par l'unité de calcul pour résoudre le système des équations affines ayant les valeurs des amplitudes en phase et en quadrature de phase du signal à mesurer comme inconnues.

Selon une deuxième conception possible de l'unité de calcul, celle-ci peut réaliser une résolution au premier ordre en fonction de l'amplitude du signal à mesurer, du système des équations affines ayant pour inconnues les valeurs d'amplitudes en phase a·cosΦ et en quadrature de phase a·sinΦ du signal à mesurer. Une telle méthode est adaptée lorsque l'amplitude du signal à mesurer est très inférieure à celle du signal de référence. Dans ce cas, l'unité de calcul peut être adaptée pour déterminer des valeurs approchées des coefficients de l'amplitude en phase et de l'amplitude en quadrature de phase dans le système d'équations affines, ces valeurs approchées des coefficients étant indépendantes des valeurs sélectionnées de la phase du signal de référence, et les valeurs sélectionnées de la phase du signal de référence constituant des termes affines du système d'équations affines. Alors, l'unité de calcul peut être adaptée en outre pour calculer des valeurs approchées des amplitudes en phase et en quadrature de phase du signal à mesurer comme de simples combinaisons linéaires des valeurs sélectionnées de la phase du signal de référence.

Selon une troisième conception possible de l'unité de calcul, celle-ci peut réaliser une résolution du système d'équations affines en décomposant en composantes fondamentales et harmoniques les valeurs de la phase du signal de référence qui sont sélectionnées par le registre à bascule. Plus précisément, l'unité de calcul peut être adaptée pour calculer des amplitudes de composantes fondamentales en phase et en quadrature de phase, et de composantes harmoniques, pour les valeurs sélectionnées de la phase du signal de référence. Alors, l'unité de calcul peut être adaptée en outre pour calculer des valeurs approchées des amplitudes en phase a·cosΦ et en quadrature de phase a·sinΦ du signal à mesurer à partir de combinaisons linéaires des amplitudes des composantes fondamentales en phase et en quadrature de phase et des composantes harmoniques des valeurs sélectionnées de la phase du signal de référence.

De préférence lorsque la troisième conception de l'unité de calcul est utilisée, l'unité de calcul peut être adaptée pour calculer des valeurs approchées des amplitudes des composantes fondamentales en phase et en quadrature de phase et des composantes harmoniques des valeurs sélectionnées de la phase du signal de référence, comme des combinaisons d'additions et de soustractions des valeurs sélectionnées de la phase du signal de référence. Elle peut alors être adaptée en outre pour calculer les valeurs approchées des amplitudes en phase a·cosΦ et en quadrature de phase a·sinΦ du signal à mesurer à partir de combinaisons linéaires des valeurs approchées des amplitudes des composantes fondamentales en phase et en quadrature de phase et des composantes harmoniques des valeurs sélectionnées de la phase du signal de référence. Dans ce cas, le nombre P est avantageusement un multiple de 60.

Lorsque plusieurs signaux sinusoïdaux doivent être caractérisés simultanément et continuellement, une voie d'acquisition peut être dédiée séparément à chacun de ces signaux, mais l'unité de synthèse peut être partagée entre toutes les voies d'acquisition, pour fournir à chacune d'elles le signal de référence et les valeurs instantanées de sa phase. Ainsi, un tel système qui est adapté pour fournir des valeurs d'amplitude et de retard de phase qui sont relatives à plusieurs signaux à mesurer ayant chacun des variations sinusoïdales en fonction du temps, tous avec la fréquence F, peut comprendre des voies d'acquisition qui sont dédiées respectivement et individuellement aux signaux à mesurer, chaque voie d'acquisition comprenant un comparateur et un registre à bascule adaptés et connectés comme décrit précédemment, séparément des autres voies d'acquisition. L'unité de synthèse peut alors être commune à toutes les voies d'acquisition pour transmettre le signal de référence simultanément à tous les comparateurs, et pour transmettre les valeurs instantanées de la phase du signal de référence simultanément à tous les registres à bascule. Possiblement, l'unité de calcul peut aussi être commune à toutes les voies d'acquisition pour déterminer une valeur d'amplitude et une valeur de retard séparément pour chaque signal à mesurer auquel est dédiée une des voies d'acquisition.

Dans des modes particuliers de réalisation de l'invention, le système peut comprendre :

- une entrée pour recevoir un signal d'horloge ;

- un premier accumulateur cyclique, qui est adapté pour générer une phase de signal d'excitation à partir du signal d'horloge conformément à un premier incrément d'accumulation ;

- un second accumulateur cyclique, qui est adapté pour générer une phase du signal de référence à partir du signal d'horloge conformément à un second incrément d'accumulation ;

- une première unité de mise en forme de signal, pour produire le signal d'excitation avec une forme sinusoïdale de variations temporelles à partir de la phase qui est générée par le premier accumulateur cyclique ; et

- une seconde unité de mise en forme de signal, pour produire le signal de référence à partir de la phase qui est générée par le second accumulateur cyclique.

Le système peut alors être adapté pour fournir le signal d'excitation à un dispositif externe, et pour recueillir le signal à mesurer en tant que réponse de ce dispositif externe au signal d'excitation. Pour cela, les premier et second incréments d'accumulation sont des nombres entiers positifs, tels qu'un quotient du premier incrément d'accumulation par Q soit égal à un quotient du second incrément d'accumulation par P, et égal aussi à un nombre entier positif appelé incrément de cycle. De cette façon, la fréquence F peut être égale à un premier produit d'une fréquence du signal d'horloge par le nombre Q et par l'incrément de cycle, divisé par $2^{NA}$ où NA est le nombre de bits utilisés dans chaque accumulateur cyclique, et la fréquence de référence $F_{ref}$ peut être égale à un second produit de la fréquence du signal d'horloge par le nombre P et par l'incrément de cycle, divisé par $2^{NA}$.

La sortie du second accumulateur cyclique est alors connectée en entrée au registre à bascule de chaque voie d'acquisition pour transmettre les valeurs instantanées de la phase du signal de référence, et la sortie de la seconde unité de mise en forme de signal est simultanément connectée en entrée au comparateur de chaque voie d'acquisition pour transmettre le signal de référence lui-même.

Un second aspect de l'invention propose un procédé pour fournir une valeur d'amplitude et une valeur de retard de phase qui sont relatives à un signal à mesurer ayant des variations sinusoïdales en fonction du temps avec une fréquence F selon la revendication 11.

Un tel procédé peut être exécuté en utilisant un système qui est conforme au premier aspect de l'invention.

Avantageusement, un procédé conforme à l'invention peut être utilisé pour caractériser une réponse d'un résonateur qui est mis en vibration par un signal d'excitation ayant une forme sinusoïdale de variations temporelles avec la fréquence F. Le signal à mesurer est alors constitué par la réponse du résonateur au signal d'excitation. En particulier, le résonateur peut être une partie d'un accéléromètre vibrant ou d'un gyromètre vibrant, et les valeurs d'amplitude et de retard de phase qui sont relatives au signal à mesurer sont utilisées ensuite pour calculer des valeurs d'accélération ou de vitesse de rotation d'un appareil ou d'un véhicule porteur de l'accéléromètre ou gyromètre.

D'autres particularités et avantages de la présente invention apparaîtront dans la description ci-après d'exemples de réalisation non limitatifs, en référence aux dessins annexés, dans lesquels :

- la figure 1 est un schéma synoptique d'un système conforme à l'invention ;
- la figure 2 est un diagramme temporel qui montre des valeurs de phase sélectionnées par un système conforme à l'invention ;
- les figures 3a à 3c reproduisent trois formes d'un système d'équations affines ayant pour inconnues des amplitudes en phase et en quadrature de phase d'un signal à mesurer ;
- la figure 4a reproduit une décomposition en série de Fourier de valeurs de phase utilisées dans l'invention ;
- la figure 4b illustre une façon de calculer des valeurs approchées pour des coefficients de Fourier des valeurs de phase utilisées dans l'invention ; et
- la figure 5 correspond à la figure 1 pour un perfectionnement de l'invention, qui est adapté pour plusieurs signaux à mesurer simultanément.

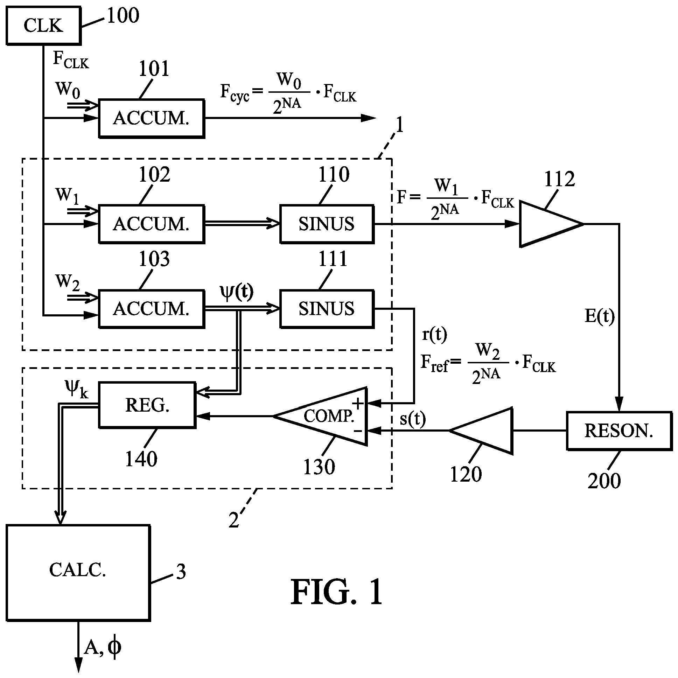

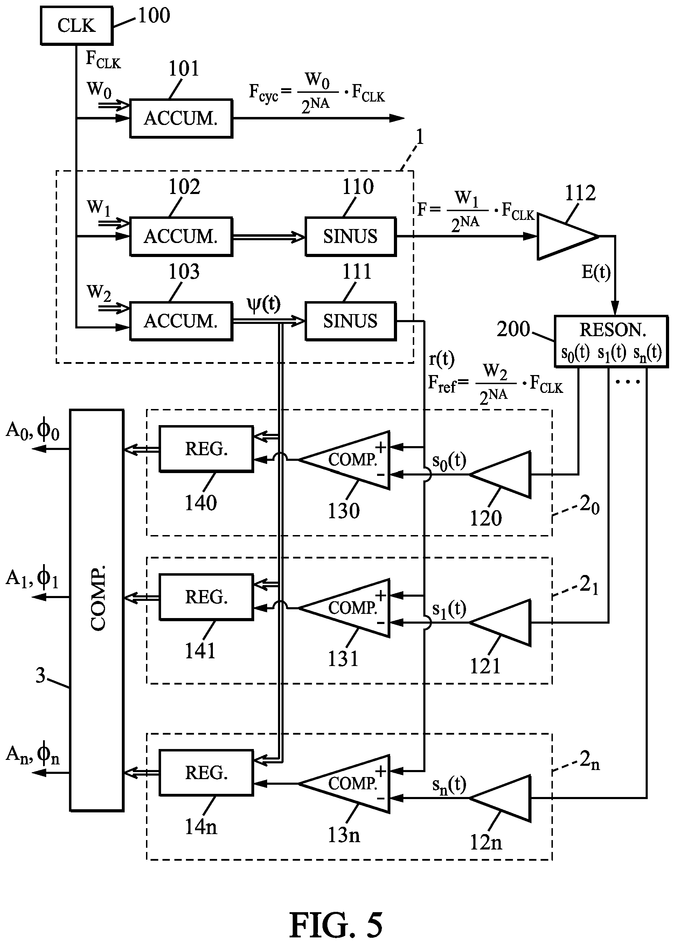

Dans les figures 1 et 5, les flèches en traits doubles indiquent des transmissions de mots binaires, et les flèches en traits simples indiquent des transmissions de signaux analogiques.

Un système conforme à l'invention est destiné à caractériser un signal sinusoïdal, dit signal à mesurer et noté s(t), dont la fréquence de variation temporelle est supposée connue. Ce signal à mesurer est donc de la forme :

$$s(t) = A \cdot \sin(2\pi \cdot F \cdot t - \Phi) \tag{1}$$

où t désigne le temps, F est la fréquence connue du signal s(t), et A et Φ sont respectivement l'amplitude et le retard de phase du signal s(t). Le but de l'invention est donc de déterminer les valeurs de l'amplitude A et du retard de phase Φ.

Pour cela, l'invention met en œuvre un autre signal sinusoïdal, dit signal de référence et noté r(t), qui est entièrement connu et généré de façon à être en cohérence de phase continuelle avec le signal à mesurer s(t). On entend par cohérence de phase continuelle entre les signaux s(t) et r(t) la propriété de ces signaux qui consiste à évoluer chacun selon sa fréquence respective, à partir d'une différence de phase qui existe initialement entre les deux signaux. Autrement dit, chaque signal présente une stabilité fréquentielle telle qu'il conserve, au moins sur la durée nécessaire pour caractériser le signal à mesurer s(t), une valeur fixe pour son propre retard de phase. En sélectionnant de façon adéquate l'instant initial défini par t = 0, le signal de référence peut s'écrire sous la forme :

$$r(t) = - A_{ref} \cdot \sin(2\pi \cdot F_{ref} \cdot t) \qquad (2)$$

Autrement dit, l'instant initial t = 0 est défini de sorte que le signal de référence r(t) présente un retard de phase égal à $\pi$. $A_{ref}$ et $F_{ret}$ sont respectivement l'amplitude et la fréquence de variation temporelle du signal de référence r(t), supposées connues. Dans la suite, la phase du signal de référence r(t) est notée $\psi(t)$ : $\psi(t) = 2\pi \cdot F_{ref} \cdot t$.

Sur la figure 1, le signal de référence r(t) est généré par l'unité de synthèse 1. Selon une réalisation possible de l'unité de synthèse 1 qui est particulièrement adaptée à l'invention, celle-ci peut comprendre un accumulateur cyclique 103, dit second accumulateur cyclique dans la partie générale de cette description et noté ACCUM., qui reçoit en entrée un signal périodique délivré par une horloge 100, notée CLK. L'horloge 100 peut être externe à l'unité de synthèse 1, et notamment être partagée avec d'autres systèmes ou modules électroniques externes au système de l'invention. L'accumulateur cyclique 103 produit donc en sortie une rampe linéaire qui est réinitialisée automatiquement, à la fréquence $F_{ret} = F_{CLK} \cdot W_2/2^{NA}$, où $F_{CLK}$ est la fréquence de l'horloge 100, $W_2$ est un incrément d'accumulation fixé, et NA est le nombre de bits utilisés pour l'accumulateur cyclique. Une unité de mise en forme de signal 111, notée SINUS, transforme la rampe qui est produite par l'accumulateur cyclique 103 en un signal sinusoïdal, encore à la fréquence $F_{ref}$. De façon connue, l'unité de mise en forme de signal 111 peut être réalisée sous la forme d'une table de conversion numérique («lookup table» en anglais) qui est combinée avec un convertisseur numérique-analogique, ou sous la forme d'un transformateur de filtrage, etc. Le signal qui est produit par l'unité 111 est le signal de référence r(t), et le signal qui est généré par l'accumulateur cyclique 103 est la phase de ce signal de référence r(t), notée $\psi(t)$ où t désigne encore le temps.

En fait, pour de nombreuses applications de l'invention, le signal à mesurer s(t) est une réponse d'un résonateur, référencé 200, noté RESON. et aussi appelé couramment oscillateur forcé, à un signal d'excitation. Ce signal d'excitation, noté E(t), a donc la même fréquence F que le signal à mesurer s(t). Les signaux d'excitation E(t) et à mesurer s(t) sont donc naturellement en cohérence de phase continuelle l'un avec l'autre, et il faut alors assurer que le signal d'excitation E(t) et le signal de référence r(t) soient eux-mêmes en cohérence de phase continuelle entre eux. Une façon préférée de garantir une telle cohérence de phase continuelle entre le signal d'excitation E(t) et le signal de référence r(t) consiste à générer ce dernier aussi à l'aide de l'unité de synthèse 1. Pour cela, l'unité de synthèse 1 peut aussi comprendre un autre accumulateur cyclique 102, dit premier accumulateur cyclique dans la partie générale de cette description, qui reçoit aussi en entrée le signal périodique délivré par l'horloge 100. L'accumulateur cyclique 102 produit en sortie une autre rampe linéaire qui est réinitialisée automatiquement, à la fréquence $F = F_{CLK} \cdot W_1/2^{NA}$, où $W_1$ est un autre incrément d'accumulation fixé. $W_1$ et $W_2$ ont été appelés premier et second incréments d'accumulation, respectivement, dans la partie générale de la présente description.

L'unité de mise en forme de signal 110 transforme la rampe qui est produite par l'accumulateur cyclique 102 en un autre signal sinusoïdal, qui possède la fréquence F. Cette unité de mise en forme de signal 110 peut aussi être réalisée sous la forme d'une table de conversion numérique qui est combinée avec un convertisseur numérique-analogique, ou sous la forme d'un transformateur de filtrage, etc. Le signal qui est produit par l'unité 110, puis possiblement amplifié par un amplificateur 112, est le signal d'excitation E(t).

Les incréments d'accumulation $W_1$ et $W_2$ sont des nombres entiers positifs, choisis en outre tels que $W_1/Q = W_2/P = W_0$, où P et Q sont deux nombres entiers positifs, non nuls, fixes, avec P plus grand que Q. Ainsi : $F_{ref} = F_{CLK} \cdot (P \cdot W_0)/2^{NA}$, $F = F_{CLK} \cdot (Q \cdot W_0)/2^{NA}$, et donc $F_{ref} = F \cdot P/Q$. La fréquence $F_{ref}$ du signal de référence r(t) est par conséquent supérieure à la fréquence F du signal à mesurer s(t). Par exemple, la fréquence d'horloge $F_{CLK}$ peut être égale à 300 MHz, et le nombre NA de bits utilisés dans les accumulateurs cycliques 102 et 103 peut être 32. Dans ce cas, le rapport de $F_{ret}$ sur $F_{CLK}$ peut être de 1/1000 environ, à titre d'exemple.

En outre, les nombres P et Q peuvent être avantageusement choisis de sorte que $W_0$ soit aussi un nombre entier positif, appelé incrément de cycle. Dans ce cas, l'unité de synthèse 1 peut comporter encore un autre accumulateur cyclique, référencé 101 dans la figure 1, qui reçoit aussi le signal d'horloge à la fréquence $F_{CLK}$, et qui possède l'incrément de cycle $W_0$ en tant qu'incrément d'accumulation. L'accumulateur cyclique 101 produit donc en sortie une rampe linéaire qui est réinitialisée périodiquement à la fréquence $F_{cyc} = F_{CLK} \cdot W_0/2^{NA}$. Ainsi, $F_{ret} = F_{cyc} \cdot P$ et $F = F_{cyc} \cdot Q$ : la période

temporelle du signal de référence r(t) est P fois plus courte que celle du signal produit par l'accumulateur cyclique 101, et la période temporelle du signal à mesurer s(t) est Q fois plus courte que celle du signal produit par l'accumulateur cyclique 101. Cet accumulateur produit donc un signal de synchronisation de cycle.

Le signal à mesurer s(t) est récupéré du résonateur 200, possiblement par l'intermédiaire d'un amplificateur 120. Des exemples de résonateur 200 seront donnés plus loin, à la fin de la présente description. Le signal à mesurer s(t) est alors traité par la voie d'acquisition 2, puis par l'unité de calcul 3, notée CALC. Cette dernière produit comme résultats des valeurs numériques pour l'amplitude A et le retard de phase Φ du signal à mesurer s(t).

La voie d'acquisition 2 comprend un comparateur 130, noté COMP., et un registre à bascule 140, noté REG. Le comparateur 130 reçoit sur deux entrées séparées le signal de référence r(t) et le signal à mesurer s(t). Il produit en sortie un signal de comparaison qui présente des transitions chaque fois que le signal de référence r(t) devient plus grand que le signal à mesurer s(t). Bien que la suite de la présente description soit conforme à ce fonctionnement du comparateur 130, un fonctionnement équivalent peut être obtenu avec un comparateur qui produit des transitions dans le signal de comparaison chaque fois que le signal à mesurer s(t) devient plus grand que le signal de référence r(t). Le signal de comparaison est ensuite transmis au registre à bascule 140, qui reçoit simultanément sur une entrée séparée, la valeur instantanée de la phase $\psi(t)$ du signal de référence r(t), de la part de l'accumulateur cyclique 103. Le registre à bascule 140 transmet alors en sortie, successivement, les valeurs de la phase $\psi(t)$ aux instants où le signal de référence r(t) est devenu plus grand que le signal à mesurer s(t). Ces valeurs, notées $\psi_k$ et numérotées par le nombre entier k à partir de 1, sont ensuite transmises à l'unité de calcul 3.

L'unité de calcul 3 est avantageusement réalisée sous la forme d'un circuit spécialisé, ou ASIC, ou d'un circuit logique programmable, ou FPGA. Possiblement, les fonctions du comparateur 130 et du registre à bascule 140 peuvent aussi être exécutées par cet ASIC ou ce FGPA.

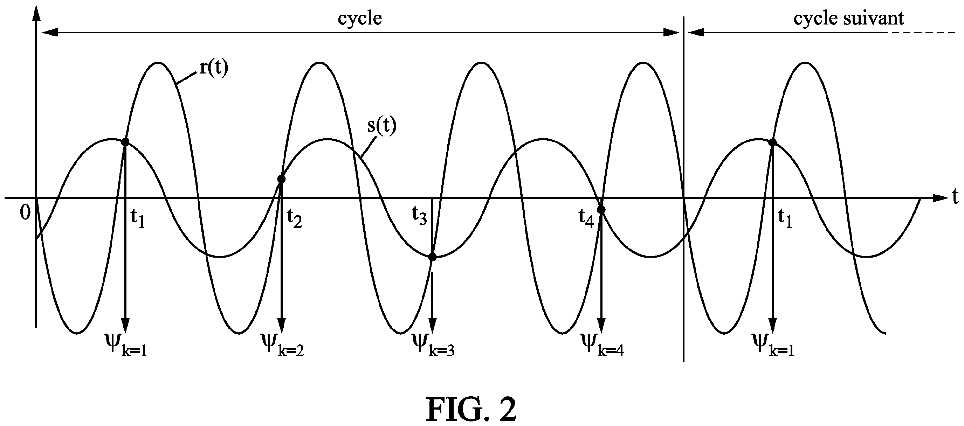

La figure 2 est un diagramme temporel des signaux r(t) et s(t). Elle montre les instants $t_1$, $t_2$, $t_3$ $t_k$,... auxquels le signal de référence r(t) devient supérieur au signal à mesurer s(t). Les valeurs correspondantes de la phase $\psi(t)$ du signal de référence r(t) sont respectivement $\psi_{k=1} = \psi(t_1)$ notée $\psi_1$ dans la suite, $\psi_{k=2} = \psi(t_2)$ notée $\psi_2$, $\psi_{k=3} = \psi(t_3)$ notée $\psi_3$,..., $\psi_k = \psi(t_k)$,... L'indice k décompte ainsi les périodes successives du signal de référence r(t) à partir de l'instant initial t=0. Les deux séries des amplitudes et des valeurs de phase $\psi_k$ aux points d'intersection entre les courbes des signaux r(t) et s(t) sont périodiques, selon la durée de période égale à $1/F_{cyc}$. Cette durée de période définit un cycle d'acquisition des valeurs de phase $\psi_k$ qui convient pour mettre en œuvre l'invention. Des cycles d'acquisition successifs peuvent alors être régis par le signal qui est généré par l'accumulateur cyclique 101, introduit plus haut, et l'indice k varie de 1 à P au cours de chaque cycle d'acquisition, de durée individuelle $1/F_{cyc}$.

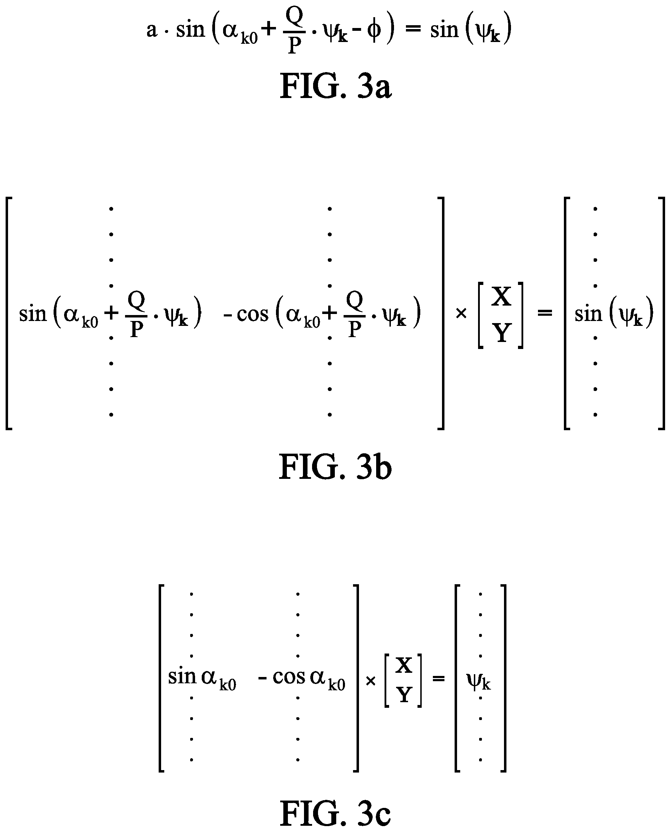

De façon générale pour l'invention, le nombre P peut être égal au nombre Q augmenté d'une unité : P = Q + 1. Par exemple, Q peut être pris égal à 3 et P peut être pris égal à 4. La figure 3 correspond à ces valeurs de P et Q, et montre un cycle d'acquisition complet avec le début du cycle suivant.

Les équations satisfaites par les instants $t_k$ sont $s(t_k) = r(t_k)$, soit :

$$A \cdot \sin[2\pi \cdot (Q/P) \cdot F_{ref} \cdot t_k - \Phi] = -A_{ref} \cdot \sin(2\pi \cdot F_{ref} \cdot t_k) \qquad (3)$$

D'après le fonctionnement de la voie d'acquisition 2 :

$$2\pi \cdot F_{ref} \cdot t_k = \psi_k + 2 \cdot k\pi - \pi \qquad (4)$$

Les équations (3) deviennent alors, pour chaque valeur de k :

$$A \cdot \sin[(Q/P) \cdot (\psi_k + (2k-1)\pi) - \Phi] = A_{ref} \cdot \sin(\psi_k) \qquad (5)$$

En notant $a=A/A_{ref}$ et $\alpha_{k0} = (Q/P) \cdot (2k-1)\pi$, les équations qui sont satisfaites par les valeurs de phase $\psi_k$ sont, comme reproduites en figure 3a :

$$a \cdot \sin[\alpha_{k0} + (Q/P) \cdot \psi_k - \Phi] = \sin(\psi_k) \qquad (6)$$

La valeur $A_{ref}$ de l'amplitude du signal de référence r(t) est enregistrée pour être utilisée ultérieurement par l'unité de calcul 3. En développant le sinus du premier membre, il vient:

$$a \cdot \sin[\alpha_{k0} + (Q/P) \cdot \psi_k] \cdot \cos(\Phi) - a \cdot \cos[\alpha_{k0} + (Q/P) \cdot \psi_k] \cdot \sin(\Phi) = \sin(\psi_k) \quad (7)$$

On effectue alors le changement de variables suivant, qui introduit l'amplitude en phase X et l'amplitude en quadrature de phase Y du signal à mesurer s(t):

$$X = a \cdot \cos(\Phi) \quad\quad\quad\quad\quad (8a)$$

$$Y = a \cdot \sin(\Phi) \quad\quad\quad\quad\quad (8b)$$

Les équations (7) deviennent alors pour chaque valeur de k, en fonction des nouvelles inconnues X et Y qui remplacent $A_{ref}$ et $\Phi$ dans une première phase de la résolution :

$$\sin[\alpha_{k0} + (Q/P) \cdot \psi_k] \cdot X - \cos[\alpha_{k0} + (Q/P) \cdot \psi_k] \cdot Y = \sin(\psi_k) \quad (9)$$

ce qui correspond à l'écriture matricielle de la figure 3b.

La résolution du système d'équations (9) fournit les valeurs des amplitudes en phase X et en quadrature de phase Y du signal à mesurer s(t). A partir de ces valeurs pour X et Y, les équations (8a) et (8b) donnent les valeurs de a et du retard de phase $\Phi$, par exemple par $a = (X^2 + Y^2)^{1/2}$ et $\Phi = Arctan(Y/X)$, puis l'amplitude A du signal à mesurer s(t) est calculée comme le produit $a \cdot A_{ref}$. Par conséquent, la suite de la présente description est focalisée sur la résolution du système d'équations (9), correspondant à la figure 3b, en proposant plusieurs méthodes alternatives pour cette résolution, qui peuvent être mises en œuvre par l'unité de calcul 3 : méthode de résolution exacte, méthode de résolution approchée, et méthode par décomposition en série de Fourier des valeurs de phase $\psi_k$.

**Résolution exacte :**

Le système d'équations (9), correspondant à l'écriture matricielle de la figure 3b, avec les deux amplitudes X et Y comme inconnues, est un système d'équations affines dont les coefficients dépendent des valeurs de phase $\psi_k$ qui ont été délivrées par la voie d'acquisition 2. Ces coefficients, $\sin[\alpha_{k0} + (Q/P) \cdot \psi_k]$ et $-\cos[\alpha_{k0} + (Q/P) \cdot \psi_k]$ pour chaque valeur de k correspondant à une équation distincte, sont alors calculés par l'unité de calcul 3, puis le système peut être résolu exactement par l'une des méthodes connues de l'Homme du métier : inversion matricielle du système formé par deux des équations (9), ou résolution par la méthode des moindres carrés, etc. Lorsque la méthode par inversion matricielle est utilisée, la matrice 2x2 des coefficients de X et Y dans deux des équations (9) est calculée, puis inversée, et la matrice inverse est appliquée aux seconds membres $\sin(\psi_k)$ des deux équations (9) utilisées, pour obtenir les valeurs de X et Y. Cependant, la méthode de résolution par les moindres carrés est plus précise, car elle utilise toutes les équations (9).

Par ailleurs, les coefficients $\sin[\alpha_{k0} + (Q/P) \cdot \psi_k]$ et $-\cos[\alpha_{k0} + (Q/P) \cdot \psi_k]$ étant variables en fonction des valeurs de phase $\psi_k$ qui ont été délivrées par la voie d'acquisition 2, les calculs des valeurs du sinus et du cosinus qui constituent les coefficients de X et Y dans les équations (9) peuvent aussi être consommateurs en temps et en moyens de calcul. Il est alors possible de remplacer les fonctions sinus et cosinus par leurs développements limités, de préférence au moins jusqu'à l'ordre cinq pour limiter les erreurs qui en résultent sur les valeurs de X et Y.

**Résolution approchée pour des faibles valeurs de a :**

Cette méthode peut être appliquée lorsque l'amplitude $A_{ref}$ du signal de référence r(t) est ou peut être ajustée pour être beaucoup plus grande que l'amplitude A du signal à mesurer s(t). Autrement dit: a<<1, et d'après l'équation (6), les valeurs de phase $\psi_k$ sont très inférieures à $\pi$, et donc aussi très inférieures aux valeurs des $\alpha_{k0}$. Dans ces conditions, les équations (6) deviennent :

$$a \cdot \sin(\alpha_{k0} - \Phi) \approx \psi_k \quad\quad\quad\quad (10)$$

c'est-à-dire en fonction des inconnues X et Y:

$$X \cdot \sin(\alpha_{k0}) - Y \cdot \cos(\alpha_{k0}) \approx \psi_k \qquad (11)$$

ce qui correspond à l'écriture matricielle de la figure 3c.

Cette fois, les coefficients $\sin(\alpha_{k0})$ et $-\cos(\alpha_{k0})$, respectivement de X et Y dans le système d'équations affines (11), sont constants. Ils peuvent donc être pré-calculés. La matrice 2x2 du système formé par deux quelconques des équations (11) peut alors aussi être inversée préalablement, et la matrice inverse peut être enregistrée pour être disponible directement pour l'unité de calcul 3. Les valeurs des amplitudes X et Y peuvent alors être calculées simplement en appliquant cette matrice inverse aux seconds membres $\psi_k$ des deux équations (11) utilisées. Un tel enregistrement préalable de la matrice inverse peut aussi être utilisé pour la méthode de résolution par les moindres carrés.

**Méthode par décomposition en série de Fourier**

Comme déjà vu, la série des valeurs de phase $\psi_k$ est périodique avec pour période temporelle $1/F_{cyc}$. Or les valeurs successives de $\alpha_{k0}$ aussi. On cherche donc à résoudre le système d'équations (9) en exprimant les valeurs de phase $\psi_k$ sous forme d'une combinaison linéaire de $\sin(\alpha_{k0})$, $\cos(\alpha_{k0})$, $\sin(2 \cdot \alpha_{k0})$, $\cos(2 \cdot \alpha_{k0})$, $\sin(3 \cdot \alpha_{k0})$, $\cos(3 \cdot \alpha_{k0})$, ... soit :

$$\psi_k = \Sigma_{i=1, 2, 3, ..., P} \, [H_{ip} \cdot \cos(i \cdot \alpha_{k0}) + H_{iq} \cdot \sin(i \cdot \alpha_{k0}) \qquad (12)$$

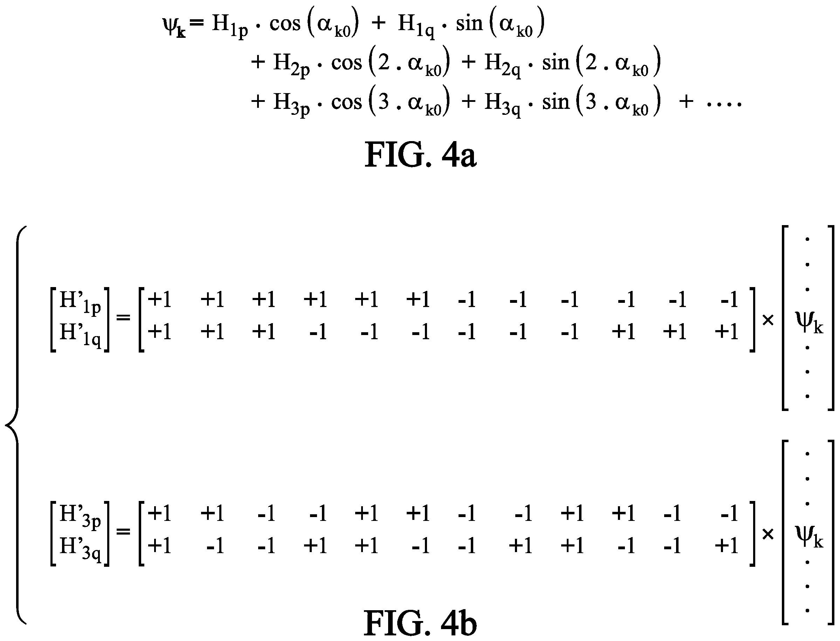

ce qui correspond à l'écriture développée de la figure 4a. Cette écriture est la décomposition des valeurs de phase $\psi_k$ en série de Fourier, sur la base des valeurs $\alpha_{k0}$. $H_{1p}$ est ainsi l'amplitude de la composante fondamentale en phase des valeurs $\psi_k$, $H_{1q}$ est l'amplitude de la composante fondamentale en quadrature phase des valeurs $\psi_k$, et les coefficients $H_{ip}$ et $H_{iq}$ pour i supérieur à 1 sont les amplitudes des composantes harmoniques d'ordre i.

Or, l'équation (9) peut s'écrire :

$$[X \cdot \sin(\alpha_{k0}) - Y \cdot \cos(\alpha_{k0})] \cdot \cos((Q/P) \cdot \psi_k)$$

$$+ \, [X \cdot \cos(\alpha_{k0}) + Y \cdot \sin(\alpha_{k0})] \cdot \sin((Q/P) \cdot \psi_k) - \sin(\psi_k) = 0 \quad (13)$$

En y développant $\cos((Q/P) \cdot \psi_k)$, $\sin((Q/P) \cdot \psi_k)$ et $\sin(\psi_k)$ en série de Fourier de $(Q/P) \cdot \psi_k$ et $\psi_k$, et en y reportant l'expression (12) de $\psi_k$, puis en convertissant tous les termes de la forme $\sin^n(i \cdot \alpha_{k0})$ et $\cos^n(i \cdot \alpha_{k0})$ en des combinaisons linéaires de termes de la forme $\sin(n' \cdot i \cdot \alpha_{k0})$ et $\cos(n' \cdot i \cdot \alpha_{k0})$, on obtient une combinaison linéaire nulle des termes $\sin(n \cdot i \cdot \alpha_{k0})$ et $\cos(n \cdot i \cdot \alpha_{k0})$. Chacun des facteurs de cette combinaison linéaire doit donc être nul, ce qui conduit à un système d'équations affines dont les inconnues sont les coefficients $H_{ip}$ et $H_{iq}$, i décrivant l'ensemble des entiers naturels non nuls, inférieurs ou égaux à P. Les premiers coefficients de la décomposition de $\psi_k$ en série de Fourier qui sont ainsi obtenus sont :

$$H_{1p} = X + [(P^2 - Q^2)/(8P^2)] \cdot X^3 + [(P^2 - Q^2)/(8P^2)] \cdot X \cdot Y^2 + \text{terme en } X^4 + \ldots \quad (14a)$$

$$H_{2p} = (Q/2P) \cdot X^2 + \text{terme en } X^4 + \ldots \qquad (14b)$$

$$H_{3p} = [(P^2 - 9Q^2)/(24P^2)] \cdot X^3 + [(P^2 - 9Q^2)/(8P^2)] \cdot X \cdot Y^2 + \text{terme en } X^4 + \ldots \quad (14c)$$

$$H_{4p} = [(P^2 Q - 4Q^3)/(2P^3)] \cdot X^2 \cdot Y^2 + \text{terme en } X^4 + \ldots \qquad (14d)$$

$$H_{5p} = -[(9P^4 - 250P^2 Q^2 + 625Q^4) \cdot Y^2/(192P^4)] \cdot X^3 + \text{terme en } X^5 \qquad (14e)$$

$$\ldots$$

$$H_{1q} = Y + [(P^2 - Q^2)/(8P^2)] \cdot X^2 \cdot Y + \text{terme en } Y^3 + \dots \tag{14f}$$

$$H_{2q} = (Q \cdot X/P) \cdot Y + \text{terme en } Y^3 + \dots \tag{14g}$$

$$H_{3q} = [(-P^2 + 9Q^2)/(8P^2)] \cdot X^2 \cdot Y + \text{terme en } Y^3 + \dots \tag{14h}$$

$\dots$

Par ailleurs, les coefficients $H_{ip}$ et $H_{iq}$ de la décomposition en série de Fourier peuvent être calculés de façon usuelle à partir des valeurs de phase $\psi_k$ qui sont délivrées par la voie d'acquisition 2. Toutefois, il est possible de calculer plus rapidement des valeurs approchées des coefficients $H_{1p}$ et $H_{1q}$, notées $H'_{1p}$ et $H'_{1q}$, en appliquant la première relation matricielle de la figure 4b aux valeurs de phase $\psi_k$ (exemple donné avec P égal à 12). Les valeurs ainsi calculées $H'_{1p}$ et $H'_{1q}$ sont ensuite utilisées directement en tant que valeurs de $H_{1p}$ et $H_{1q}$. Afin de calculer dans les mêmes conditions de simplicité les coefficients des amplitudes harmoniques d'ordre 3 et 5, il faut que le nombre P soit aussi multiple de 3 et 5, en plus d'être multiple de 4 pour les calculs simplifiés de $H_{1p}$, $H_{1q}$, et $H_{2p}$, $H_{2q}$, et aussi $H_{4p}$, $H_{4q}$. Pour mettre en œuvre de telles simplifications calculatoires, P est donc préférablement multiple de 60. Lorsque le nombre P est encore égal à 12, la seconde relation matricielle de la figure 4b montre le calcul des valeurs approchées des coefficients $H_{3p}$ et $H_{3q}$, notées $H'_{3p}$ et $H'_{3q}$.

En identifiant les premiers coefficients $H_{ip}$ et $H_{iq}$ de la décomposition de Fourier des valeurs de phase $\psi_k$, calculées à partir de celles-ci telles que délivrées par la voie d'acquisition 2, avec les expressions des équations (14a-14h), les amplitudes X et Y peuvent être obtenues de façon approchée en combinant plusieurs des équations (14a-14h) de la façon suivante :

$$X \approx H_{1p} + 3 \cdot H_{3p} \cdot (P^2 - Q^2)/(P^2 - 9 \cdot Q^2) + H_{5p} \cdot (P^2 - Q^2)/(P^2 - 25 \cdot Q^2) \tag{15a}$$

$$Y \approx H_{1q} - H_{3q} \cdot (P^2 - Q^2)/(P^2 - 9 \cdot Q^2) \tag{15b}$$

Ainsi, une valeur approchée de X peut être calculée simplement en combinant linéairement, avec des facteurs de combinaison qui sont fixes et prédéterminés, les valeurs des trois amplitudes de composantes de Fourier $H_{1p}$, $H_{3p}$ et $H_{5p}$ seulement. Parallèlement, une valeur approchée de Y peut être calculée simplement en combinant linéairement les valeurs des deux amplitudes de composantes de Fourier $H_{1q}$ et $H_{3q}$ seulement. Pour les combinaisons des équations (15a-15b), les premiers termes négligés sont en $X \cdot Y^2$. D'autres combinaisons peuvent être utilisées alternativement pour calculer des valeurs approchées des amplitudes X et Y, en négligeant des termes en $X^3$ au lieu de ceux en $X \cdot Y^2$.

A noter qu'il est possible de rendre maximale la valeur de l'amplitude en phase X du signal à mesurer s(t) par rapport à celle en quadrature de phase Y en appliquant initialement une rotation entre les P valeurs de phase $\psi_k$. Une telle rotation revient à décaler l'instant initial t=0 pour réduire le retard de phase $\Phi$. Cela permet de minimiser les termes croisés résiduels en $X \cdot Y^2$ dans $H_{ip}$.

La figure 5 correspond à la figure 1 lorsque le résonateur 200, ou de façon équivalente un ensemble de résonateurs référencé 200, produit simultanément plusieurs réponses au signal d'excitation unique E(t). Tel est le cas, par exemple, lorsque le résonateur ou l'ensemble de résonateurs 200 est une partie d'un accéléromètre vibrant ou d'un gyromètre vibrant. Chaque signal à mesurer, noté $s_0(t)$, $s_1(t)$,..., $s_n(t)$, constitue une réponse distincte au signal d'excitation unique E(t), et une voie d'acquisition séparée est dédiée à chacun de ces signaux à mesurer. Ainsi, la voie d'acquisition $2_0$, comprenant le comparateur 130 et le registre à bascule 140, et aussi possiblement l'amplificateur 120, est dédiée au signal à mesurer $s_0(t)$. De même, la voie d'acquisition $2_1$, comprenant le comparateur 131 et le registre à bascule 141, et aussi possiblement l'amplificateur 121, est dédiée au signal à mesurer $s_1(t)$,..., la voie d'acquisition $2_n$, comprenant le comparateur 13n et le registre à bascule 14n, et aussi possiblement l'amplificateur 12n, est dédiée au signal à mesurer $s_n(t)$. Les comparateurs 130, 131,..., 13n reçoivent en parallèle le signal de référence r(t) de la part de l'unité de mise en forme de signal 111, et les registres à bascule 140, 141,..., 14n reçoivent en parallèle la phase $\psi(t)$ du signal de référence r(t) de la part de l'accumulateur cyclique 103. L'unité de synthèse 1 est ainsi partagée entre toutes les voies d'acquisition $2_0$, $2_1$,.... $2_n$. L'unité de calcul 3 peut aussi être partagée entre toutes les voies d'acquisition $2_0$, $2_1$,..., $2_n$, par exemple en fonctionnant alternativement, par périodes d'acquisition successives, à partir des valeurs de phase qui sont délivrées par l'une ou l'autre des voies d'acquisition. L'unité 3 détermine ainsi les valeurs d'amplitude et de retard de phase de tous les signaux à mesurer : $A_0$ et $\Phi_0$ pour le signal à mesurer $s_0(t)$, $A_1$ et $\Phi_1$ pour le signal à mesurer $s_1(t)$,.... $A_n$ et $\Phi_n$ pour le signal à mesurer $s_n(t)$.

Lorsque l'ensemble de résonateurs 200 est un accéléromètre, il peut être constitué d'au moins trois poutres qui sont mises en tension chacune par une masse d'inertie, et orientées différemment des autres poutres, par exemple selon trois directions perpendiculaires. Chaque poutre peut être mise en oscillation transversalement par le signal d'excitation $E(t)$, et les signaux à mesurer $s_1(t)$, $s_2(t)$ et $s_3(t)$ peuvent caractériser des déplacements instantanés par vibrations transversales, respectivement pour les trois poutres. Alors, l'Homme du métier sait déduire les trois composantes d'une accélération d'entrainement à partir des valeurs d'amplitudes et de retards de phases $A_1$ et $\Phi_1$, $A_2$ et $\Phi_2$, et $A_3$ et $\Phi_3$, respectivement des signaux à mesurer $s_1(t)$, $s_2(t)$ et $s_3(t)$.

Lorsque le résonateur 200 est un gyromètre, il peut être constitué par une structure vibrante à au moins quatre modes propres de vibration qui sont susceptibles d'être couplés par un champ de force de Coriolis. Les signaux à mesurer $s_1(t)$, $s_2(t)$ et $s_3(t)$ peuvent alors caractériser les couplages entre un mode propre d'excitation et trois modes propres distincts qui sont couplés au mode propre d'excitation par le champ de force de Coriolis. Le signal d'excitation $E(t)$ est appliqué au mode propre d'excitation, et des signaux de déplacements instantanés qui sont relatifs aux trois autres modes propres de vibration constituent les trois signaux à mesurer $s_1(t)$, $s_2(t)$ et $s_3(t)$. Alors, l'Homme du métier sait déduire les trois composantes d'une rotation d'entrainement à partir des valeurs d'amplitudes et de retards de phases $A_1$ et $\Phi_1$, $A_2$ et $\Phi_2$, et $A_3$ et $\Phi_3$, respectivement des trois signaux à mesurer $s_1(t)$, $s_2(t)$ et $s_3(t)$.

L'accélération d'entrainement ou la rotation d'entrainement qui est ainsi mesurée peut résulter notamment du mouvement d'un appareil ou d'un véhicule porteur de l'accéléromètre ou gyromètre, tel qu'un aéronef, un satellite, un véhicule spatial, etc.

## Revendications

1. Système pour fournir une valeur d'amplitude (A) et une valeur de retard de phase ($\Phi$) relatives à un signal à mesurer ($s(t)$) ayant des variations sinusoïdales en fonction du temps ($t$) avec une fréquence F, ledit système comprenant :

   - une unité de synthèse (1), adaptée pour générer un signal de référence ($r(t)$) ayant une forme sinusoïdale de variations temporelles, en cohérence de phase continuelle avec le signal à mesurer ($s(t)$), ledit signal de référence ayant une amplitude ($A_{ref}$) plus grande que l'amplitude (A) du signal à mesurer ($s(t)$), et ayant une fréquence égale à $F_{ref} = F \times P/Q$, où P et Q sont deux nombres entiers positifs non nuls, fixes, P étant plus grand que Q ;
   - un comparateur (130) connecté pour recevoir sur deux entrées dudit comparateur le signal à mesurer ($s(t)$) et le signal de référence ($r(t)$), et adapté pour produire en sortie une transition de signal à chaque instant où le signal à mesurer devient plus petit que le signal de référence, ou bien à chaque instant où le signal à mesurer devient plus grand que le signal de référence ;
   - un registre à bascule (140) connecté pour recevoir des valeurs instantanées sur une entrée de données dudit registre, et pour recevoir un signal produit en sortie par le comparateur (130) sur une entrée de validation dudit registre, et adapté pour sélectionner celles ($\psi_k$) des valeurs instantanées qui sont reçues par ledit registre en même temps qu'une transition du signal produit par le comparateur, le comparateur et le registre formant ainsi une voie d'acquisition (2) pour le signal à mesurer ($s(t)$) ; et
   - une unité de calcul (3) connectée pour recevoir les valeurs sélectionnées, et adaptée pour calculer les valeurs de l'amplitude (A) et du retard de phase ($\Phi$) du signal à mesurer ($s(t)$) à partir desdites valeurs sélectionnées,

   **caractérisé en ce que** le registre à bascule (140) est connecté pour recevoir des valeurs instantanées d'une phase ($\psi(t)$) du signal de référence ($r(t)$) sur l'entrée de données dudit registre, et l'unité de calcul (3) est connectée pour recevoir les valeurs sélectionnées ($\psi_k$) de la phase ($\psi(t)$) du signal de référence ($r(t)$), et est adaptée pour calculer les valeurs de l'amplitude (A) et du retard de phase ($\Phi$) du signal à mesurer ($s(t)$) à partir desdites valeurs sélectionnées de la phase du signal de référence, et **en ce que** l'unité de calcul (3) est adaptée pour calculer une valeur d'amplitude en phase (X) du signal à mesurer ($s(t)$), égale à $a \cdot \cos\Phi$ où $\Phi$ est la valeur du retard de phase du signal à mesurer et a est un quotient de l'amplitude (A) du signal à mesurer ($s(t)$) par l'amplitude ($A_{ref}$) du signal de référence ($r(t)$), et une valeur d'amplitude en quadrature de phase (Y) du signal à mesurer, égale à $a \cdot \sin\Phi$, à partir d'un système d'équations affines ayant des coefficients, pour l'amplitude en phase (X) et l'amplitude en quadrature de phase (Y) du signal à mesurer ($s(t)$), qui dépendent des valeurs sélectionnées ($\psi_k$) de la phase du signal de référence ($r(t)$).

2. Système selon la revendication 1, dans lequel le nombre P est égal au nombre Q augmenté d'une unité.

3. Système selon la revendication 1 ou 2, dans lequel au moins un parmi l'unité de synthèse (1), le registre à bascule (140) et l'unité de calcul (3) est formé par un circuit logique programmable (FPGA) ou par un circuit spécialisé (ASIC).

4.  Système selon l'une quelconque des revendications 1 à 3, dans lequel l'unité de calcul (3) est adaptée pour calculer les coefficients du système d'équations affines à partir des valeurs sélectionnées ($\psi_k$) de la phase du signal de référence (r(t)), et pour calculer les valeurs des amplitudes en phase (X) et en quadrature de phase (Y) du signal à mesurer (s(t)) en appliquant un algorithme de résolution dudit système d'équations affines, par exemple un algorithme d'inversion d'équations affines ou un algorithme de résolution par moindres carrés.

5.  Système selon l'une quelconque des revendications 1 à 3, dans lequel l'unité de calcul (3) est adaptée pour déterminer des valeurs approchées des coefficients de l'amplitude en phase (X) et de l'amplitude en quadrature de phase (Y) du signal à mesurer s(t) dans le système d'équations affines, lesdites valeurs approchées des coefficients étant indépendantes des valeurs sélectionnées ($\psi_k$) de la phase du signal de référence (r(t)), et lesdites valeurs sélectionnées de la phase du signal de référence constituant des termes affines dudit système d'équations affines, et l'unité de calcul est adaptée en outre pour calculer des valeurs approchées des amplitudes en phase (X) et en quadrature de phase (Y) du signal à mesurer (s(t)) comme des combinaisons linéaires des valeurs sélectionnées de la phase du signal de référence.

6.  Système selon l'une quelconque des revendications 1 à 3, dans lequel l'unité de calcul (3) est adaptée pour calculer des amplitudes de composantes fondamentales en phase ($H_{1p}$) et en quadrature de phase ($H_{1q}$) et de composantes harmoniques ($H_{2p}$, $H_{2q}$,...) pour les valeurs sélectionnées ($\psi_k$) de la phase du signal de référence (r(t)), et l'unité de calcul est adaptée en outre pour calculer des valeurs approchées des amplitudes en phase (X) et en quadrature de phase (Y) du signal à mesurer (s(t)) à partir de combinaisons linéaires desdites amplitudes des composantes fondamentales en phase et en quadrature de phase et des composantes harmoniques des valeurs sélectionnées de la phase du signal de référence.

7.  Système selon la revendication 6, dans lequel l'unité de calcul (3) est adaptée pour calculer des valeurs approchées des amplitudes des composantes fondamentales en phase ($H_{1p}$) et en quadrature de phase ($H_{1q}$) et des composantes harmoniques ($H_{2p}$, $H_{2q}$,...) des valeurs sélectionnées ($\psi_k$) de la phase du signal de référence (r(t)), comme des combinaisons d'additions et de soustractions desdites valeurs sélectionnées de la phase du signal de référence, et l'unité de calcul est adaptée en outre pour calculer les valeurs approchées des amplitudes en phase (X) et en quadrature de phase (Y) du signal à mesurer (s(t)) à partir de combinaisons linéaires des valeurs approchées des amplitudes des composantes fondamentales en phase et en quadrature de phase et des composantes harmoniques des valeurs sélectionnées de la phase du signal de référence.

8.  Système selon la revendication 7, dans lequel P est un multiple de 60.

9.  Système selon l'une quelconque des revendications précédentes, adapté pour fournir des valeurs d'amplitude (A) et de retard de phase ($\Phi$) relatives à plusieurs signaux à mesurer ($s_0(t)$, $s_1(t)$,...) ayant chacun des variations sinusoïdales en fonction du temps (t), lesdits signaux à mesurer ayant tous la fréquence F, ledit système comprenant des voies d'acquisition ($2_0$, $2_1$,...) respectives dédiées individuellement aux signaux à mesurer ($s_0(t)$, $s_1(t)$,...), chaque voie d'acquisition comprenant un comparateur (130, 131,...) et un registre à bascule (140, 141,...) adaptés et connectés conformément à la revendication 1, séparément des autres voies d'acquisition, l'unité de synthèse (1) étant commune à toutes les voies d'acquisition ($2_0$, $2_1$,...) pour transmettre le signal de référence (r(t)) simultanément à tous les comparateurs (130, 131,...), et pour transmettre les valeurs instantanées de la phase ($\psi(t)$) dudit signal de référence simultanément à tous les registres à bascule (140, 141,...).

10. Système selon l'une quelconque des revendications précédentes, dans lequel l'unité de synthèse (1) comprend

    - une entrée pour recevoir un signal d'horloge ;
    - un premier accumulateur cyclique (102) adapté pour générer une phase de signal d'excitation (E(t)) à partir du signal d'horloge conformément à un premier incrément d'accumulation ($W_1$) ;
    - un second accumulateur cyclique (103) adapté pour générer une phase ($\psi(t)$) du signal de référence (r(t)) à partir du signal d'horloge conformément à un second incrément d'accumulation ($W_2$) ;
    - une première unité de mise en forme de signal (110) pour produire le signal d'excitation (E(t)) avec une forme sinusoïdale de variations temporelles à partir de la phase générée par le premier accumulateur cyclique (102) ; et
    - une seconde unité de mise en forme de signal (111) pour produire le signal de référence (r(t)) à partir de la phase ($\psi(t)$) générée par le second accumulateur cyclique (103) ;

le système étant adapté pour fournir le signal d'excitation (E(t)) à un dispositif externe (200), et pour recueillir le signal à mesurer (s(t)) en tant que réponse dudit dispositif externe au signal d'excitation,

et dans lequel les premier ($W_1$) et second ($W_2$) incréments d'accumulation sont des nombres entiers positifs, tels qu'un quotient du premier incrément d'accumulation ($W_1$) par Q soit égal à un quotient du second incrément d'accumulation ($W_2$) par P, et égal aussi à un nombre entier positif ($W_0$) appelé incrément de cycle,

de sorte que la fréquence F soit égale à un premier produit d'une fréquence ($F_{CLK}$) du signal d'horloge par le nombre Q et par l'incrément de cycle ($W_0$), divisé par $2^{NA}$, où NA est le nombre de bits utilisés dans chaque accumulateur cyclique (102, 103),

et la fréquence de référence $F_{ref}$ soit égale à un second produit de la fréquence ($F_{CLK}$) du signal d'horloge par le nombre P et par l'incrément de cycle ($W_0$), divisé par $2^{NA}$.

11. Procédé pour fournir une valeur d'amplitude (A) et une valeur de retard de phase ($\Phi$) relatives à un signal à mesurer (s(t)) ayant des variations sinusoïdales en fonction du temps (t) avec une fréquence F, ledit procédé comprenant les étapes suivantes :

- générer un signal de référence (r(t)) ayant une forme sinusoïdale de variations temporelles, en cohérence de phase continuelle avec le signal à mesurer (s(t)), ledit signal de référence ayant une amplitude ($A_{ref}$) plus grande que l'amplitude (A) du signal à mesurer, et ayant une fréquence égale à $F_{ref}$ = F x P/Q, où P et Q sont deux nombres entiers positifs non nuls, fixes, P étant plus grand que Q ;
- sélectionner des valeurs instantanées pour lesquelles le signal à mesurer (s(t)) devient plus petit que le signal de référence, ou bien pour lesquelles le signal à mesurer devient plus grand que le signal de référence ; et
- calculer les valeurs de l'amplitude (A) et du retard de phase ($\Phi$) du signal à mesurer (s(t)) à partir des valeurs sélectionnées,

**caractérisé en ce que** les valeurs instantanées qui sont sélectionnées sont des valeurs instantanées ($\psi_k$) d'une phase ($\psi$(t)) du signal de référence (r(t)),

et les valeurs de l'amplitude (A) et du retard de phase ($\Phi$) du signal à mesurer (s(t)) sont calculées à partir des valeurs sélectionnées ($\psi_k$) de la phase du signal de référence (r(t)),

et **en ce qu'**une unité de calcul (3) calcule une valeur d'amplitude en phase (X) du signal à mesurer (s(t)), égale à a · cos$\Phi$ où $\Phi$ est la valeur du retard de phase du signal à mesurer et a est un quotient de l'amplitude (A) du signal à mesurer (s(t)) par l'amplitude ($A_{ref}$) du signal de référence (r(t)), et une valeur d'amplitude en quadrature de phase (Y) du signal à mesurer, égale à a · sin$\Phi$, à partir d'un système d'équations affines ayant des coefficients, pour l'amplitude en phase (X) et l'amplitude en quadrature de phase (Y) du signal à mesurer (s(t)), qui dépendent des valeurs sélectionnées ($\psi_k$) de la phase du signal de référence (r(t)).

12. Procédé selon la revendication 11, exécuté en utilisant un système conforme à l'une quelconque des revendications 1 à 10.

13. Procédé selon la revendication 11 ou 12, utilisé pour caractériser une réponse d'un résonateur mis en vibration par un signal d'excitation (E(t)) ayant une forme sinusoïdale de variations temporelles avec la fréquence F, le signal à mesurer (s(t)) étant la réponse dudit résonateur au signal d'excitation.

14. Procédé selon la revendication 13, suivant lequel le résonateur est une partie d'un accéléromètre vibrant ou d'un gyromètre vibrant, et les valeurs d'amplitude (A) et de retard de phase ($\Phi$) relatives au signal à mesurer (s(t)) sont utilisées ensuite pour calculer des valeurs d'accélération ou de vitesse de rotation d'un appareil ou d'un véhicule porteur de l'accéléromètre ou gyromètre.

**Patentansprüche**

1. System zum Bereitstellen eines Amplitudenwerts (A) und eines Phasenverzögerungswerts ($\Phi$) relativ zu einem zu messenden Signal (s(t)), welches sinusförmige Variationen als Funktion der Zeit (t) mit einer Frequenz F aufweist, wobei das System umfasst:

- eine Syntheseeinheit (1), welche dazu eingerichtet ist, ein Referenzsignal (r(t)) zu erzeugen, welches eine sinusförmige Form mit zeitlichen Variationen aufweist, in kontinuierlicher Phasenkohärenz mit dem zu messenden Signal (s(t)), wobei das Referenzsignal eine Amplitude ($A_{ref}$) aufweist, welche größer als die Amplitude (A) des zu messenden Signals (s(t)) ist, und eine Frequenz aufweist, welche gleich $F_{ref}$ = F x P/Q ist, wobei P und Q zwei feste positive Ganzzahlen ungleich Null sind, wobei P größer als Q ist;

- ein Vergleichselement (130), welches dazu verbunden ist, an zwei Eingängen des Vergleichselements das zu messende Signal (s(t)) und das Referenzsignal (r(t)) zu empfangen, und dazu eingerichtet ist, an einem Ausgang einen Signalübergang zu jedem Zeitpunkt zu erzeugen, zu welchem das zu messende Signal kleiner als das Referenzsignal wird, oder zu jedem Zeitpunkt, zu welchem das zu messende Signal größer als das Referenzsignal wird;

- ein Kippstufenregister (140), welches dazu verbunden ist, momentane Werte an einem Dateneingang des Registers zu empfangen und ein Signal, welches an einem Ausgang durch das Vergleichselement (130) erzeugt worden ist, an einem Validierungseingang des Registers zu empfangen, und dazu eingerichtet ist, diejenigen ($\psi_k$) der momentanen Werte auszuwählen, welche von dem Register zur selben Zeit wie ein von dem Vergleichselement erzeugtes Übergangssignal empfangen werden, wobei das Vergleichselement und das Register somit einen Aufnahmeweg (2) für das zu messende Signal (s(t)) bilden; und

- eine Berechnungseinheit (3), welche dazu verbunden ist, die ausgewählten Werte zu empfangen, und dazu eingerichtet ist, die Werte der Amplitude (A) und der Phasenverzögerung (Φ) des zu messenden Signals (s(t)) ausgehend von den ausgewählten Werten zu berechnen,

**dadurch gekennzeichnet, dass** das Kippstufenregister (140) dazu verbunden ist, momentane Werte einer Phase ($\psi(t)$) des Referenzsignals (r(t)) an dem Dateneingang des Registers zu empfangen,

und die Berechnungseinheit (3) dazu verbunden ist, die ausgewählten Werte ($\psi_k$) der Phase ($\psi(t)$) des Referenzsignals (r(t)) zu empfangen, und dazu eingerichtet ist, die Werte der Amplitude (A) und der Phasenverzögerung (Φ) des zu messenden Signals (s(t)) ausgehend von den ausgewählten Werten der Phase des Referenzsignals zu berechnen,

und dadurch, dass die Berechnungseinheit (3) dazu eingerichtet ist, einen Amplitudenwert in Phase (X) des zu messenden Signals (s(t)) gleich a*cosΦ zu berechnen, wobei Φ der Wert der Phasenverzögerung des zu messenden Signals ist und a ein Quotient der Amplitude (A) des zu messenden Signals (s(t)) durch die Amplitude ($A_{ref}$) des Referenzsignals (r(t)) ist, sowie einen Amplitudenwert in Quadratur der Phase (Y) des zu messenden Signals gleich a*sinΦ, ausgehend von einem System von affinen Gleichungen, welches Koeffizienten für die Amplitude in Phase (X) und die Amplitude in Quadratur der Phase (Y) des zu messenden Signals (s(t)) aufweist, welche von den ausgewählten Werten ($\psi_k$) der Phase des Referenzsignals (r(t)) abhängen.

2. System nach Anspruch 1, wobei die Zahl P gleich der Zahl Q erhöht um eine Einheit ist.

3. System nach Anspruch 1 oder 2, wobei wenigstens eines aus der Syntheseeinheit (1), dem Kippstufenregister (140) und der Berechnungseinheit (3) durch eine programmierbare logische Schaltung (FPGA) oder durch eine spezialisierte Schaltung (ASIC) gebildet ist.

4. System nach einem der Ansprüche 1 bis 3, wobei die Berechnungseinheit (3) dazu eingerichtet ist, die Koeffizienten des Systems von affinen Gleichungen ausgehend von den ausgewählten Werten ($\psi_k$) der Phase des Referenzsignals (r(t)) zu berechnen und die Amplitudenwerte in Phase (X) und in Quadratur der Phase (Y) des zu messenden Signals (s(t)) zu berechnen, indem ein Algorithmus zum Lösen des Systems von affinen Gleichungen angewendet wird, beispielsweise ein Algorithmus zur Inversion der affinen Gleichungen oder ein Algorithmus zum Lösen durch kleinste Quadrate.

5. System nach einem der Ansprüche 1 bis 3, wobei die Berechnungseinheit (3) dazu eingerichtet ist, näherungsweise Werte der Koeffizienten der Amplitude in Phase (X) und der Amplitude in Quadratur der Phase (Y) des zu messenden Signals s(t) in dem System von affinen Gleichungen zu bestimmen, wobei die näherungsweisen Werte der Koeffizienten unabhängig von den ausgewählten Werten ($\psi_k$) der Phase des Referenzsignals (r(t)) sind, und wobei die ausgewählten Werte der Phase des Referenzsignals affine Terme des Systems von affinen Gleichungen bilden und die Berechnungseinheit ferner dazu eingerichtet ist, näherungsweise Werte der Amplituden in Phase (X) und in Quadratur der Phase (Y) des zu messenden Signals (s(t)) als lineare Kombinationen der ausgewählten Werte der Phase des Referenzsignals zu berechnen.

6. System nach einem der Ansprüche 1 bis 3, wobei die Berechnungseinheit (3) dazu eingerichtet ist, Amplituden von fundamentalen Komponenten in Phase ($H_{1p}$) und in Quadratur der Phase ($H_{1q}$) und harmonische Komponenten ($H_{2p}$, $H_{2q}$, ...) für die ausgewählten Werte ($\psi_k$) der Phase des Referenzsignals (r(t)) zu berechnen, und die Berechnungseinheit ferner dazu eingerichtet ist, näherungsweise Werte der Amplituden in Phase (X) und in Quadratur der Phase (Y) des zu messenden Signals (s(t)) ausgehend von linearen Kombinationen der Amplituden der fundamentalen Komponenten in Phase und in Quadratur der Phase und harmonischen Komponenten der ausgewählten Werte der Phase des Referenzsignals zu berechnen.

7. System nach Anspruch 6, wobei die Berechnungseinheit (3) dazu eingerichtet ist, näherungsweise Werte der Amplituden der fundamentalen Komponenten in Phase ($H_{1p}$) und in Quadratur der Phase ($H_{1q}$) und harmonische Komponenten ($H_{2p}$, $H_{2q}$, ...) der ausgewählten Werte ($\psi_k$) der Phase des Referenzsignals ($r(t)$) als Kombinationen von Additionen und Subtraktionen der ausgewählten Werte der Phase des Referenzsignals zu berechnen, und die Berechnungseinheit ferner dazu eingerichtet ist, die näherungsweisen Werte der Amplituden in Phase ($X$) und in Quadratur der Phase ($Y$) des zu messenden Signals ($s(t)$) ausgehend von linearen Kombinationen der näherungsweisen Werte der Amplituden der fundamentalen Komponenten in Phase und in Quadratur der Phase und harmonischen Komponenten der ausgewählten Werte der Phase des Referenzsignals zu berechnen.

8. System nach Anspruch 7, wobei P ein Vielfaches von 60 ist.

9. System nach einem der vorhergehenden Ansprüche, dazu eingerichtet Werte der Amplitude ($A$) und der Phasenverzögerung ($\Phi$) bezüglich mehreren zu messenden Signalen ($s_0(t)$, $s_1(t)$, ...) bereitzustellen, welche jeweils sinusförmige Variationen als Funktion der Zeit ($t$) aufweisen, wobei die zu messenden Signale alle die Frequenz F aufweisen,
wobei das System Aufnahmewege ($2_0$, $2_1$, ...) umfasst, welche jeweils individuell den zu den zu messenden Signalen ($s_0(t)$, $s_1(t)$, ...) gewidmet sind, wobei jeder Aufnahmeweg ein Vergleichselement (130, 131,...) und ein Kippstufenregister (140, 141, ...) umfasst, welche gemäß Anspruch 1 getrennt von den anderen Aufnahmewegen eingerichtet und verbunden sind,
wobei die Syntheseeinheit (1) für alle Aufnahmewege ($2_0$, $2_1$, ...) gemeinsam ist, um das Referenzsignal ($r(t)$) gleichzeitig an alle der Vergleichselemente (130, 131, ...) zu übertragen und um die momentanen Werte der Phase ($\psi(t)$) des Referenzsignals gleichzeitig an alle der Kippstufenregister (140, 141, ...) zu übertragen.

10. System nach einem der vorhergehenden Ansprüche, wobei die Syntheseeinheit (1) umfasst:

- einen Eingang zum Empfangen eines Uhrensignals;
- einen ersten zyklischen Akkumulator (102), welcher dazu eingerichtet ist, eine Phase eines Anregungssignals ($E(t)$) ausgehend von dem Uhrensignal entsprechend einem ersten Akkumulationsinkrement ($W_1$) zu erzeugen;
- einen zweiten zyklischen Akkumulator (103), welcher dazu eingerichtet ist, eine Phase ($\psi(t)$) des Referenzsignals ($r(t)$) ausgehend von dem Uhrensignal entsprechend einem zweiten Akkumulationsinkrement ($W_2$) zu erzeugen;
- eine erste Signalformungseinheit (110) zum Erzeugen des Anregungssignals ($E(t)$) mit einer sinusförmigen Form mit zeitlichen Variationen ausgehend von der Phase, welche durch den ersten zyklischen Akkumulator (102) erzeugt worden ist; und
- eine zweite Signalformungseinheit (111) zum Erzeugen des Referenzsignals ($r(t)$) ausgehend von der Phase ($\psi(t)$), welche von dem zweiten zyklischen Akkumulator (103) erzeugt worden ist;

wobei das System dazu eingerichtet ist, das Anregungssignal ($E(t)$) für eine externe Vorrichtung (200) bereitzustellen und das zu messende Signal ($s(t)$) als eine Reaktion der externen Vorrichtung auf das Anregungssignal zu erhalten, und wobei die ersten ($W_1$) und zweiten ($W_2$) Akkumulationsinkremente positive Ganzzahlen sind, so dass ein Quotient des ersten Akkumulationsinkrements ($W_1$) durch Q gleich einem Quotienten des zweiten Akkumulationsinkrements ($W_2$) durch P und ebenfalls gleich einer positiven Ganzzahl ($W_0$) ist, welche als Zyklusinkrement bezeichnet wird,
so dass die Frequenz F gleich einem ersten Produkt einer Frequenz ($F_{CLK}$) des Uhrensignals durch die Zahl Q und durch das Zyklusinkrement ($W_0$) geteilt durch $2^{NA}$ ist, wobei NA die Anzahl von Bits ist, welche in jedem zyklischen Akkumulator (102, 103) verwendet werden,
und die Referenzfrequenz $F_{ref}$ gleich einem zweiten Produkt der Frequenz ($F_{CLK}$) des Uhrensignals durch die Zahl P und durch das Zyklusinkrement ($W_0$) geteilt durch $2^{NA}$ ist.

11. Verfahren zum Bereitstellen eines Amplitudenwerts ($A$) und eines Phasenverzögerungswerts ($\Phi$) relativ zu einem zu messenden Signal ($s(t)$), welches sinusförmige Variationen als Funktion der Zeit ($t$) mit einer Frequenz F aufweist, wobei das Verfahren die folgenden Schritte umfasst:

- Erzeugen eines Referenzsignals ($r(t)$), welches eine sinusförmige Form mit zeitlichen Variationen aufweist, in kontinuierlicher Phasenkohärenz mit dem zu messenden Signal ($s(t)$), wobei das Referenzsignal eine Amplitude ($A_{ref}$) aufweist, welche größer als die Amplitude ($A$) des zu messenden Signals ist, und eine Frequenz aufweist, welche gleich $F_{ref}$ = F x P/Q ist, wobei P und Q zwei feste positive Ganzzahlen ungleich Null sind, wobei P größer als Q ist;
- Auswählen von momentanen Werten, für welche das zu messende Signal (s(t)) kleiner als das Referenzsignal wird oder für welche das zu messende Signal größer als das Referenzsignal wird; und
- Berechnen der Werte der Amplitude (A) und der Phasenverzögerung (Φ) des zu messenden Signals (s(t)) ausgehend von den ausgewählten Werten,

**dadurch gekennzeichnet, dass** die momentanen Werte, welche ausgewählt werden, momentane Werte ($\psi_k$) einer Phase ($\psi$(t)) des Referenzsignals (r(t)) sind,
und die Werte der Amplitude A und der Phasenverzögerung (Φ) des zu messenden Signals (s(t)) ausgehend von den ausgewählten Werten ($\psi_k$) der Phase des Referenzsignals (r(t)) berechnet werden,
und dadurch, dass eine Berechnungseinheit (3) einen Amplitudenwert in Phase (X) des zu messenden Signals (s(t)) gleich a*cosΦ berechnet, wobei Φ der Wert der Phasenverzögerung des zu messenden Signals ist und a ein Quotient der Amplitude (A) des zu messenden Signals (s(t)) durch die Amplitude ($A_{ref}$) des Referenzsignals (r(t)) ist, sowie einen Amplitudenwert in Quadratur der Phase (Y) des zu messenden Signals gleich a*sinΦ, ausgehend von einem System von affinen Gleichungen, welches Koeffizienten für die Amplitude in Phase (X) und die Amplitude in Quadratur der Phase (Y) des zu messenden Signals (s(t)) aufweist, welche von den ausgewählten Werten ($\psi_k$) der Phase des Referenzsignals (r(t)) abhängen.

**12.** Verfahren nach Anspruch 11, durchgeführt unter Verwendung eines Systems nach einem der Ansprüche 1 bis 10.

**13.** Verfahren nach Anspruch 11 oder 12, verwendet zum Charakterisieren einer Antwort eines Resonators, welcher durch ein Anregungssignal (E(t)) in Vibration versetzt wird, welches eine sinusförmige Form von zeitlichen Variationen mit der Frequenz F aufweist, wobei das zu messende Signal (s(t)) die Antwort des Resonators auf das Anregungssignal ist.

**14.** Verfahren nach Anspruch 13, wobei der Resonator ein Teil eines vibrierenden Beschleunigungsmesselements oder eines vibrierenden Gyrometers ist, und wobei die Werte der Amplitude (A) und der Phasenverzögerung (Φ) relativ zu dem zu messenden Signal (s(t)) sodann verwendet werden, um Werte der Beschleunigung oder der Rotationsgeschwindigkeit einer Vorrichtung oder eines Fahrzeugs zu berechnen, welches das Beschleunigungsmesselement oder das Gyrometer trägt.

**Claims**

**1.** System for providing an amplitude value (A) and a phase delay value (Φ) which relate to a signal to be measured (s(t)) having sinusoidal variations over time (t) with a frequency F, said system comprising:

- a synthesis unit (1), adapted to generate a reference signal (r(t)) having a sinusoidal form of time-variations, in continual phase coherence with the signal to be measured (s(t)), said reference signal having an amplitude ($A_{ref}$) larger than the amplitude (A) of the signal to be measured (s(t)) and having a frequency equal to $F_{ref}$ = F x P/Q, where P and Q are two fixed, non-zero positive integers, P being greater than Q;
- a comparator (130) connected to receive the signal to be measured (s(t)) and the reference signal (r(t)) on two inputs of said comparator, and adapted to output a signal transition each time the signal to be measured becomes less than the reference signal, or each time the signal to be measured becomes greater than the reference signal;
- a latch register (140) connected to receive instantaneous values on a data input of said register, and to receive a signal that is outputted by the comparator (130) on an enabling input of said register, and adapted to select those of the instantaneous values ($\psi_k$) that are received by said register at the same time as a transition of the signal produced by the comparator, the comparator and the register thus forming an acquisition channel (2) for the signal to be measured (s(t)); and
- a computation unit (3) connected to receive the selected values, and adapted to calculate the values of the amplitude (A) and phase delay (Φ) of the signal to be measured (s(t)) from said selected values,

**characterized in that** the latch register (140) is connected for receiving instantaneous values of a phase ($\psi$(t)) of the reference signal (r(t)) on the data input of said register,
and the computation unit (3) is connected for receiving the selected values ($\psi_k$) of the phase ($\psi$(t)) of the reference signal (r(t)), and is adapted for calculating the values of the amplitude (A) and phase delay (Φ) of the signal to be measured (s(t)) from said values selected for the phase of the reference signal,
and **in that** the computation unit (3) is adapted to calculate an in-phase amplitude value (X) of the signal to be measured (s(t)), equal to $a \cdot \cos\Phi$ where $\Phi$ is the value of the phase delay of the signal to be measured and a is a quotient of the amplitude (A) of the signal to be measured (s(t)) divided by the amplitude ($A_{ref}$) of the reference signal (r(t)), and a quadrature amplitude value (Y) of the signal to be measured, equal to $a \cdot \sin\Phi$, from a system of affine equations having coefficients, for the in-phase amplitude (X) and the quadrature amplitude (Y) of the signal to be measured (s(t)), which depend on the selected values ($\psi_k$) for the phase of the reference signal (r(t)).

2. System according to claim 1, wherein the integer P is equal to the integer Q plus one.

3. System according to claim 1 or 2, wherein at least one among the synthesis unit (1), the latch register (140), and the computation unit (3) is formed by a programmable logic circuit (FPGA) or a dedicated circuit (ASIC).

4. System according to any one of claims 1 to 3, wherein the computation unit (3) is adapted to calculate the coefficients of the system of affine equations from the selected values ($\psi_k$) for the phase of the reference signal (r(t)), and to calculate the values of the in-phase amplitude (X) and quadrature amplitude (Y) of the signal to be measured (s(t)) by applying an algorithm for solving said system of affine equations, for example an affine equation inversion algorithm or a least-square resolution algorithm.

5. System according to any one of claims 1 to 3, wherein the computation unit (3) is adapted to determine approximate values for the coefficients of the in-phase amplitude (X) and quadrature amplitude (Y) of the signal to be measured s(t) in the system of affine equations, said approximate values of the coefficients being independent of the selected values ($\psi_k$) for the phase of the reference signal (r(t)), and said selected values for the phase of the reference signal constituting affine terms of said system of affine equations, and the computation unit is further adapted to calculate approximate values of the in-phase amplitude (X) and quadrature amplitude (Y) of the signal to be measured (s(t)), as linear combinations of the selected values for the phase of the reference signal.

6. System according to any one of claims 1 to 3, wherein the computation unit (3) is adapted to calculate amplitudes of fundamental in-phase ($H_{1p}$) and quadrature components ($H_{1q}$) and of harmonic components ($H_{2p}$, $H_{2q}$,...) for the selected values ($\psi_k$) for the phase of the reference signal (r(t)), and the computation unit is further adapted to calculate approximate values of the in-phase amplitude (X) and quadrature amplitude (Y) of the signal to be measured (s(t)), from linear combinations of said amplitudes of the fundamental in-phase and quadrature components and the harmonic components of the selected values for the phase of the reference signal.

7. System according to claim 6, wherein the computation unit (3) is adapted to calculate approximate values for the amplitudes of the fundamental in-phase ($H_{1p}$) and quadrature ($H_{1q}$) components and the harmonic components ($H_{2p}$, $H_{2q}$,...) of the selected values ($\psi_k$) for the phase of the reference signal (r(t)), as combinations of additions and subtractions of said selected values for the phase of the reference signal, and the computation unit is further adapted to calculate approximate the values for the in-phase amplitude (X) and quadrature amplitude (Y) of the signal to be measured (s(t)), from linear combinations of the approximate values for the amplitudes of the fundamental in-phase and quadrature components and the harmonic components of the selected values for the phase of the reference signal.

8. System according to claim 7, wherein P is a multiple of 60.

9. System according to any one of the preceding claims, adapted to provide amplitude values (A) and phase delay values ($\Phi$) relating to a plurality of signals to be measured ($s_0(t)$, $s_1(t)$,...) each having sinusoidal variations over time (t), said signals to be measured all having the frequency F,
said system comprising respective acquisition channels ($2_0$, $2_1$,...) individually dedicated to the signals to be measured ($s_0(t)$, $s_1(t)$,...), each acquisition channel comprising a comparator (130, 131, ...) and a latch register (140, 141, ...) adapted and connected in accordance with claim 1, separately from the other acquisition channels, the synthesis unit (1) being common to all the acquisition channels ($2_0$, $2_1$,...), for transmitting the reference signal (r(t)) simultaneously to all the comparators (130, 131,...) and for transmitting the instantaneous values of the phase ($\psi(t)$) of said reference signal simultaneously to all the latch registers (140, 141, ...).

10. System according to any one of the preceding claims, wherein the synthesis unit (1) comprises

   - an input for receiving a clock signal;

- a first cyclic accumulator (102) adapted to generate a phase of an excitation signal (E(t)) from the clock signal in accordance with a first accumulation increment ($W_1$);
- a second cyclic accumulator (103) adapted to generate a phase ($\psi(t)$) of the reference signal (r(t)) from the clock signal in accordance with a second accumulation increment ($W_2$);
- a first signal-shaping unit (110) for producing the excitation signal (E(t)) with a sinusoidal form of time-variations, from the phase generated by the first cyclic accumulator (102); and
- a second signal-shaping unit (111) for producing the reference signal (r(t)) from the phase ($\psi(t)$) generated by the second cyclic accumulator (103);

the system being adapted to provide the excitation signal (E(t)) to an external device (200), and to collect the signal to be measured (s(t)) as a response of said external device to the excitation signal,
and wherein the first ($W_1$) and second ($W_2$) accumulation increments are positive integers, such that a quotient of the first accumulation increment ($W_1$) divided by Q is equal to a quotient of the second accumulation increment ($W_2$) divided by P, and is also equal to a positive integer ($W_0$) called cycle increment,
such that the frequency F is equal to a first product of a frequency ($F_{CLK}$) of the clock signal multiplied by the integer Q and by the cycle increment ($W_0$), divided by $2^{NA}$ where NA is the number of bits used in each cyclic accumulator (102, 103),
and the reference frequency $F_{REF}$ is equal to a second product of the frequency ($F_{OLK}$) of the clock signal multiplied by the integer P and by the cycle increment ($W_0$), divided by $2^{NA}$.

11. Method for providing an amplitude value (A) and a phase delay value ($\Phi$) which relate to a signal to be measured (s(t)) having sinusoidal variations over time (t) with a frequency F, said method comprising the following steps:

- generating a reference signal (r(t)) having a sinusoidal form of time-variations, in continual phase coherence with the signal to be measured (s(t)), said reference signal having an amplitude ($A_{ref}$) larger than the amplitude (A) of the signal to be measured, and having a frequency equal to $F_{ref} = F \times P/Q$, where P and Q are two fixed, non-zero positive integers, P being greater than Q;
- selecting instantaneous values for which the signal to be measured (s(t)) becomes smaller than the reference signal, or for which the signal to be measured becomes larger than the reference signal; and
- calculating the values of the amplitude (A) and the phase delay ($\Phi$) of the signal to be measured (s(t)) from the selected values,

**characterized in that** the instantaneous values which are selected are instantaneous values ($\psi_k$) of a phase ($\psi(t)$) of the reference signal (r(t)),
and **in that** the values of the amplitude (A) and phase delay ($\Phi$) of the signal to be measured (s(t)) are calculated from the values selected ($\psi_k$) for the phase of the reference signal (r(t)),
and **in that** a computation unit (3) calculates an in-phase amplitude value (X) of the signal to be measured (s(t)), equal to $a \cdot \cos\Phi$ where $\Phi$ is the value of the phase delay of the signal to be measured and a is a quotient of the amplitude (A) of the signal to be measured (s(t)) divided by the amplitude ($A_{ref}$) of the reference signal (r(t)), and a quadrature amplitude value (Y) of the signal to be measured, equal to $a \cdot \sin\Phi$, from a system of affine equations having coefficients, for the in-phase amplitude (X) and the quadrature amplitude (Y) of the signal to be measured (s(t)), which depend on the selected values ($\psi_k$) for the phase of the reference signal (r(t)).

12. Method according to claim 12, carried out using a system according to any one of claims 1 to 10.

13. Method according to claim 11 or 12, used for characterizing a response of a resonator vibrated by an excitation signal (E(t)) having a sinusoidal form of time-variations with frequency F, the signal to be measured (s(t)) being the response of said resonator to the excitation signal.

14. Method according to claim 13, wherein the resonator is part of a vibrating accelerometer or a vibrating gyroscope, and the values of the amplitude (A) and phase delay ($\Phi$) relating to the signal to be measured (s(t)) are then used to calculate acceleration or rotational speed values of a device or a vehicle carrying the accelerometer or gyroscope.

$$F_{cyc} = \frac{W_0}{2^{NA}} \cdot F_{CLK}$$

$$F = \frac{W_1}{2^{NA}} \cdot F_{CLK}$$

$$F_{ref} = \frac{W_2}{2^{NA}} \cdot F_{CLK}$$

FIG. 1

FIG. 2

$$a \cdot \sin\left(\alpha_{k0} + \frac{Q}{P} \cdot \psi_k - \phi\right) = \sin\left(\psi_k\right)$$

## FIG. 3a

$$\begin{bmatrix} \vdots & \vdots \\ \sin\left(\alpha_{k0} + \frac{Q}{P} \cdot \psi_k\right) & -\cos\left(\alpha_{k0} + \frac{Q}{P} \cdot \psi_k\right) \\ \vdots & \vdots \end{bmatrix} \times \begin{bmatrix} X \\ Y \end{bmatrix} = \begin{bmatrix} \vdots \\ \sin\left(\psi_k\right) \\ \vdots \end{bmatrix}$$

## FIG. 3b

$$\begin{bmatrix} \vdots & \vdots \\ \sin\alpha_{k0} & -\cos\alpha_{k0} \\ \vdots & \vdots \end{bmatrix} \times \begin{bmatrix} X \\ Y \end{bmatrix} = \begin{bmatrix} \vdots \\ \psi_k \\ \vdots \end{bmatrix}$$

## FIG. 3c

$$\psi_k = H_{1p} \cdot \cos\left(\alpha_{k0}\right) + H_{1q} \cdot \sin\left(\alpha_{k0}\right)$$
$$+ H_{2p} \cdot \cos\left(2 \cdot \alpha_{k0}\right) + H_{2q} \cdot \sin\left(2 \cdot \alpha_{k0}\right)$$
$$+ H_{3p} \cdot \cos\left(3 \cdot \alpha_{k0}\right) + H_{3q} \cdot \sin\left(3 \cdot \alpha_{k0}\right) + \ldots$$

## FIG. 4a

$$\begin{bmatrix} H'_{1p} \\ H'_{1q} \end{bmatrix} = \begin{bmatrix} +1 & +1 & +1 & +1 & +1 & +1 & -1 & -1 & -1 & -1 & -1 & -1 \\ +1 & +1 & +1 & -1 & -1 & -1 & -1 & -1 & -1 & +1 & +1 & +1 \end{bmatrix} \times \begin{bmatrix} \cdot \\ \cdot \\ \cdot \\ \psi_k \\ \cdot \\ \cdot \\ \cdot \end{bmatrix}$$

$$\begin{bmatrix} H'_{3p} \\ H'_{3q} \end{bmatrix} = \begin{bmatrix} +1 & +1 & -1 & -1 & +1 & +1 & -1 & -1 & +1 & +1 & -1 & -1 \\ +1 & -1 & -1 & +1 & +1 & -1 & -1 & +1 & +1 & -1 & -1 & +1 \end{bmatrix} \times \begin{bmatrix} \cdot \\ \cdot \\ \cdot \\ \psi_k \\ \cdot \\ \cdot \\ \cdot \end{bmatrix}$$

## FIG. 4b

EP 3 469 386 B1

FIG. 5

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 5166959 A

- WO 2008022653 A

**Littérature non-brevet citée dans la description**

- **R. MICHELETTI.** Phase Angle Measurement Between Two Sinusoïdal Signais. *IEEE Trans. Instr. Meas.,* 01 Février 1991, vol. 40, 40-42

- **B. MARÉCHAL et al.** Direct Digital Synthetizer (DDS) design parameters optimisation for vibrating MEMS sensors. *2014 SYMPOSIUM ON DESIGN, TEST, INTEGRATION AND PACKAGING OF MEMS/MOEMS (DTIP), CIRCUITS MULTI PROJETS - CMP,* 01 Avril 2014, 1-5